# FASCICULE DE BREVET EUROPEEN

(11) **EP 3 544 049 B1**
(45) Date de publication et mention de la délivrance du brevet: **30.12.2020**
(21) Numéro de dépôt: 19161945.1
(22) Date de dépôt: 11.03.2019
(51) Int. Cl.: H01L 21/683, H01L 21/687

(54) **DISPOSITIF DE PRÉHENSION D'UNE STRUCTURE MONOCOUCHE OU MULTICOUCHE COMPORTANT DES SYSTÈMES DE PRÉHENSION**
GREIFVORRICHTUNG EINER EINSCHICHTIGEN ODER MEHRSCHICHTIGEN STRUKTUR, DIE GREIFSYSTEME UMFASST
DEVICE FOR GRIPPING A SINGLE-LAYER OR MULTI-LAYER STRUCTURE COMPRISING GRIPPING SYSTEMS

(30) Priorité: 19.03.2018 FR 1852330
(43) Date de publication de la demande: 25.09.2019
(73) Titulaire: Commissariat à l'énergie atomique et aux énergies alternatives, 75015 Paris (FR)
(72) Inventeur: JERONIMO, Pedro, 38054 GRENOBLE Cedex 09 (FR)
(74) Mandataire: Brevalex

(56) Documents cités:
- EP-A1- 2 053 648
- JP-A- H10 167 469
- US-A- 5 931 518

## Description

### DOMAINE TECHNIQUE

La présente invention se rapporte au domaine des dispositifs de préhension, ou encore appelés manipulateurs ou systèmes de manipulation, de substrats comprenant une ou plusieurs couches minces, notamment de structures semi-conductrices monocouches ou multicouches, également dénommées « semiconductor wafers » en anglais, permettant notamment l'obtention de cellules photovoltaïques, et préférentiellement des cellules photovoltaïques dites « cristallines », c'est-à-dire qui sont à base de silicium monocristallin ou multicristallin, lorsque ces structures semi-conductrices correspondent à des plaquettes de silicium.

L'invention peut être mise en œuvre pour de nombreuses applications qui impliquent la manipulation de structures monocouches ou multicouches, et particulièrement pour son utilisation sur des équipements de l'industrie photovoltaïque, par exemple pour la charge et la décharge de telles structures sur des paniers de stockage ou des plateaux de détourage, ce terme correspondant à la non déposition de matière sur les bords d'un substrat ou tout autre partie du substrat en cas de masquage.

L'invention propose ainsi un dispositif de préhension d'une structure monocouche ou multicouche comportant au moins trois systèmes de préhension pourvus d'encoches de maintien en position de la structure.

### ÉTAT DE LA TECHNIQUE ANTÉRIEURE

Dans le domaine de la fabrication des cellules photovoltaïques, et en particulier des cellules photovoltaïques cristallines à base de silicium, il est nécessaire de pouvoir manipuler les plaquettes de silicium, habituellement appelées « wafers », à partir desquelles les cellules photovoltaïques sont obtenues.

De façon habituelle, la manipulation manuelle de ces plaquettes de silicium se fait à l'aide de pinces de type précelles ou brucelles. Toutefois, un des inconvénients de ces pinces est qu'il existe une grande surface de contact avec la plaquette, en particulier au niveau de la partie inférieure des pinces. Ainsi, lorsqu'on observe une cellule photovoltaïque, on peut constater la présence de traces noires à l'endroit où la plaquette a été manipulée manuellement qui correspondent à la trace des pinces précelles. Ces traces noires engendrent une détérioration des plaquettes de silicium qui impacte le rendement final des cellules photovoltaïques.

L'art antérieur enseigne par ailleurs de nombreuses solutions de manipulateurs de structures semi-conductrices reposant sur diverses technologies. Ainsi, par exemple, le brevet américain US 4,969,676 A divulgue un dispositif de manipulation au moyen d'un système d'aspiration. Néanmoins, cette solution ne permet pas une récupération aisée d'un wafer dans un panier de wafers. En outre, les demandes de brevet américains US 2002/0071756 A1 et US 2003/0077162 A1 enseignent d'autres solutions de préhenseurs non adaptés à la manipulation de plaquettes de silicium sans détérioration et situées dans un panier de plaquettes. EP 2053648 divulgue un dispositif de convoyage de substrats ainsi qu'un équipement chauffant vertical.

### EXPOSÉ DE L'INVENTION

L'invention a donc pour but de remédier au moins partiellement aux besoins mentionnés précédemment et aux inconvénients relatifs aux réalisations de l'art antérieur.

L'invention a ainsi pour objet, selon l'un de ses aspects, un dispositif de préhension d'une structure (ou substrat) monocouche ou multicouche, semi-conductrice ou non, en particulier une structure semi-conductrice multicouche, notamment une plaquette de silicium, notamment une plaquette de silicium permettant l'obtention de cellules photovoltaïques à base de silicium cristallin, caractérisé en ce qu'il comporte :
- un corps principal comprenant une face supérieure et une face inférieure, opposée à la face supérieure, le corps principal comportant un système d'aspiration de la structure situé sur la face inférieure du corps principal destinée à être en vis-à-vis de la structure,
- au moins trois systèmes de préhension de la structure, reliés au corps principal, chaque système de préhension comportant une tête de préhension, rotative selon les trois axes d'un repère cartésien, pourvue d'une encoche de maintien en position de la structure,

- au moins trois systèmes de soufflage d'un gaz sur la structure, respectivement associés auxdits au moins trois systèmes de préhension, pour maintenir la structure à distance du corps principal,
- un dispositif d'actionnement de la préhension de la structure, configuré pour assurer l'aspiration par le biais du système d'aspiration, le soufflage par le biais desdits au moins trois systèmes de soufflage et la rotation des têtes de préhension de sorte à permettre la préhension de la structure.

Grâce à l'invention, il peut être possible de manipuler une plaquette de silicium (« wafer »), ou une cellule photovoltaïque par sa tranche, de façon simple et efficace. La préhension n'engendre pas de détérioration de la plaquette ou de la cellule. De plus, l'invention peut permettre la prise d'un wafer dans un panier de wafers.

Le dispositif de préhension selon l'invention peut en outre comporter l'une ou plusieurs des caractéristiques suivantes prises isolément ou suivant toutes combinaisons techniques possibles.

Chaque système de préhension peut comporter un bras de préhension. Chaque bras de préhension peut être relié au corps principal à l'une de ses extrémités et à une tête de préhension à l'autre de ses extrémités.

Chaque système de soufflage peut être situé à la jonction entre le corps principal et un bras de préhension.

Par ailleurs, le corps principal peut présenter une forme sensiblement triangulaire, chaque bras de préhension étant relié au corps principal au niveau d'un sommet de la forme triangulaire.

Chaque tête de préhension peut être reliée au bras de préhension correspondant par le biais d'une rotule.

En outre, l'encoche de maintien en position de chaque tête de préhension peut être située à une extrémité de la tête de préhension et peut comprendre une paroi de contact sensiblement plane, destinée à venir au contact d'une surface inférieure ou supérieure de la structure, coopérant avec une paroi de contact sensiblement oblique, destinée à venir au contact d'une surface latérale de la structure, pour former l'encoche de maintien en position.

De plus, les parois de contact sensiblement plane et oblique peuvent définir entre elles un angle d'encoche strictement inférieur à 90°, et notamment supérieur ou égal à 45°.

La largeur de contact de la paroi de contact sensiblement plane avec la structure peut être comprise entre 100 µm et 1 mm, étant par exemple comprise entre 100 µm et 500 µm.

Par ailleurs, le dispositif d'actionnement peut comporter un organe de préhension manuelle pour un utilisateur, notamment relié au corps principal par le biais d'un bras d'actionnement.

Le dispositif d'actionnement peut comporter un bouton-poussoir permettant le déclenchement de l'aspiration, du soufflage et de la rotation des têtes de préhension.

La rotation des têtes de préhension peut être assurée par le dispositif d'actionnement au moyen de tiges d'actionnement reliées aux têtes de préhension et au dispositif d'actionnement.

De plus, le dispositif de préhension peut comporter des tubes creux comprenant les tiges d'actionnement, reliant les têtes de préhension au dispositif d'actionnement.

Les tubes creux peuvent être disposés, au moins en partie, sur la face supérieure du corps principal.

Les tubes creux peuvent converger au sein d'un boîtier de regroupement positionné sur la face supérieure du corps principal, notamment en superposition du système d'aspiration situé sur la face inférieure du corps principal.

En outre, le dispositif de préhension peut comporter un cadre configuré pour permettre l'insertion du dispositif de préhension dans un panier de stockage de structures.

Le dispositif de préhension selon l'invention peut comporter l'une quelconque des caractéristiques précédemment énoncées, prises isolément ou selon toutes combinaisons techniquement possibles avec d'autres caractéristiques.

### BRÈVE DESCRIPTION DES DESSINS

L'invention pourra être mieux comprise à la lecture de la description détaillée qui va suivre, d'exemples de mise en œuvre non limitatifs de celle-ci, ainsi qu'à l'examen des figures, schématiques et partielles, du dessin annexé, sur lequel :
- la figure 1 représente, en perspective et en vue du dessus, un premier exemple de dispositif de préhension conforme à l'invention,
- la figure 2 représente, en perspective et en vue du dessous, le dispositif de préhension de la figure 1,
- les figures 3 à 5 illustrent, en perspective, la rotation des têtes de préhension du dispositif de préhension de la figure 1 selon les trois axes d'un repère cartésien,
- la figure 6 illustre de façon isolée, en perspective, une tête de préhension permettant de visualiser une encoche de maintien en position,
- la figure 7 illustre, en perspective, l'état d'une tête de préhension du dispositif de préhension de la figure 1 avant préhension d'une structure monocouche ou multicouche,
- la figure 8 illustre, en perspective, l'état d'une tête de préhension du dispositif de préhension de la figure 1 après préhension d'une structure monocouche ou multicouche,
- la figure 9 représente, en perspective et en vue du dessus, le dispositif de préhension de la figure 1 avec préhension d'une structure monocouche ou multicouche,
- la figure 10 représente, en perspective et en vue du dessus, un deuxième exemple de dispositif de préhension conforme à l'invention, et
- la figure 11 illustre, en perspective, l'utilisation du dispositif de préhension de la figure 10 pour la préhension d'une structure monocouche ou multicouche dans un panier de plusieurs structures analogues.

Dans l'ensemble de ces figures, des références identiques peuvent désigner des éléments identiques ou analogues.

De plus, les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

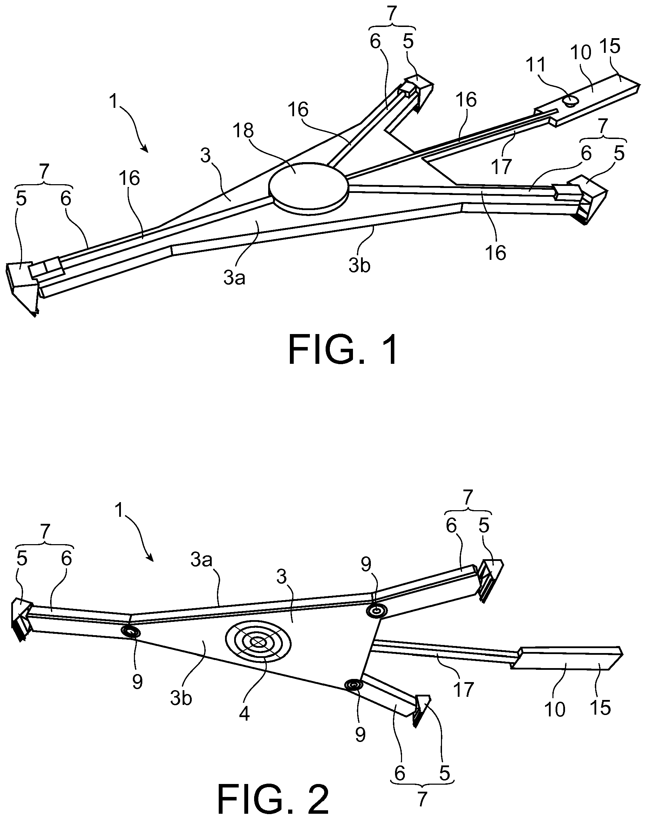

En référence aux figures 1 à 11, on va maintenant décrire deux exemples de réalisation de dispositifs de préhension 1 conformes à l'invention et leur principe de fonctionnement.

Il est à noter que, comme indiqué précédemment, les dispositifs de préhension 1 sont préférentiellement utilisés, mais non exclusivement, pour la manipulation de structures semi-conductrices monocouches ou multicouches de type « semiconductor wafers », et en particulier pour des plaquettes de silicium, notamment les plaquettes de silicium permettant l'obtention de cellules photovoltaïques à base de silicium cristallin, telles que les cellules photovoltaïque à hétérojonction ou à homojonction.

Tout d'abord, selon un premier exemple de réalisation visible sur les figures 1 à 9, le dispositif de préhension 1 conforme à l'invention comporte un corps principal 3 comprenant une face supérieure 3a et une face inférieure 3b, opposée à la face supérieure 3a.

Ce corps principal présente, dans cet exemple, une forme triangulaire. Depuis les trois sommets de cette forme triangulaire s'étendent un bras de préhension 6, de forme sensiblement rectiligne, auquel est rattachée une tête de préhension 5.

Un bras de préhension 6 et la tête de préhension 5 associée forment ensemble un système de préhension 7 de la structure 2. Ainsi, le dispositif de préhension 1 comporte trois systèmes de préhension 7 reliés au corps principal 3.

Par ailleurs, comme visible sur la figure 2, le corps principal 3 comporte un système d'aspiration 4 de la structure 2 qui est situé sur la face inférieure 3b du corps principal 3 en vis-à-vis de la structure 2.

De plus, comme également visible sur la figure 2, le dispositif de préhension 1 comporte aussi trois systèmes de soufflage 9 d'un gaz, notamment un gaz comprimé, tel que de l'azote, ou de l'air, sur la structure 2, respectivement associés aux systèmes de préhension 7, pour maintenir la structure 2 à distance du corps principal 3. Plus précisément, chaque système de soufflage 9 est situé à la jonction entre le corps principal 3 et un bras de préhension 6.

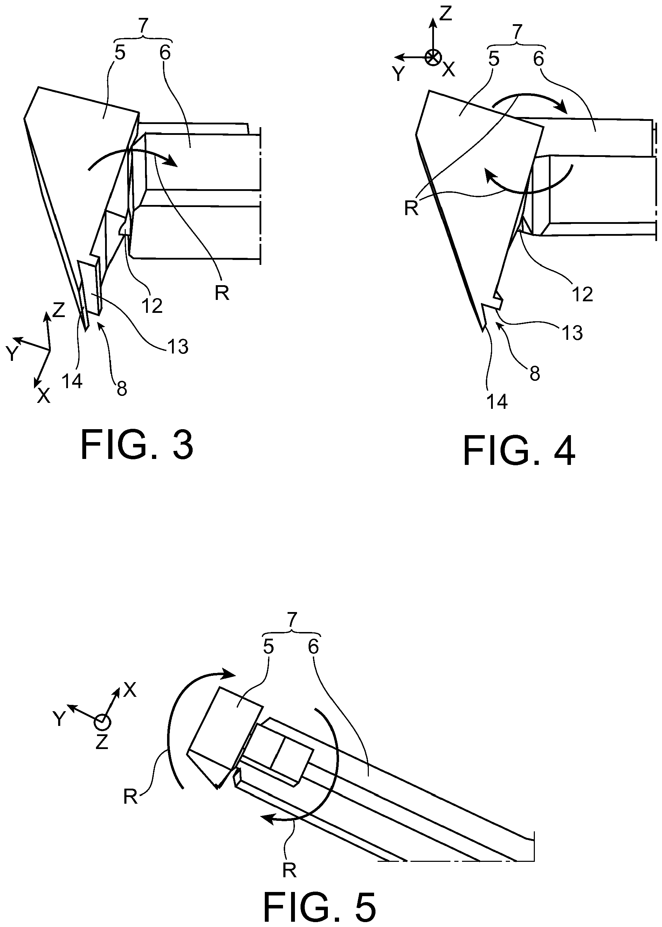

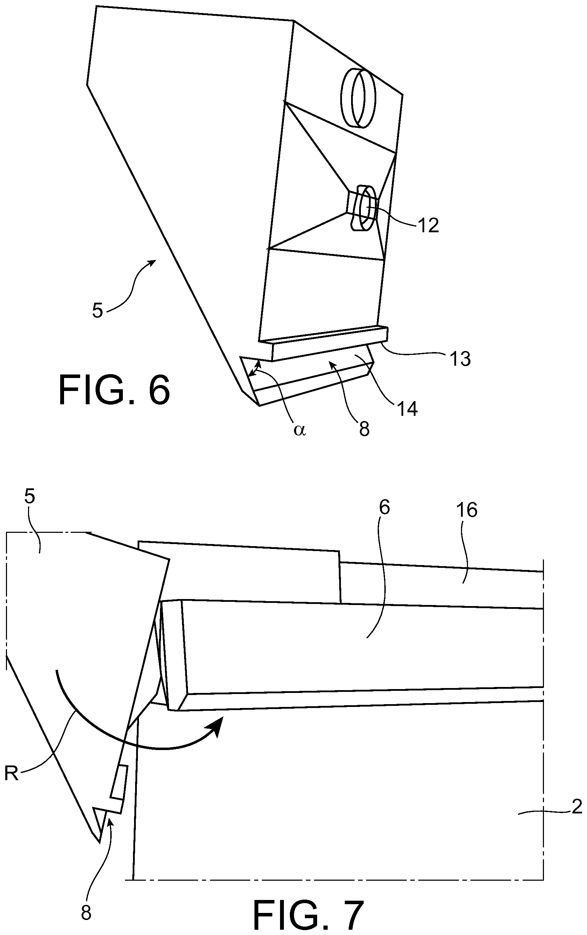

Comme schématisé par les flèches R sur les figures 3, 4, 5 et 7, chaque tête de préhension 5 est rotative selon les trois axes X, Y, Z d'un repère cartésien. Ces têtes de préhension 5 rotatives forment des systèmes élémentaires aptes à venir agripper la structure 2 pour permettre au dispositif de préhension 1 de pouvoir la soulever. Pour ce faire, chaque tête de préhension 5 comporte une encoche de maintien en position 8 de la structure 2, comme visible par exemple sur la figure 6.

De plus, chaque tête de préhension 5 est reliée au bras de préhension 6 correspondant par le biais d'une rotule 12, comme visible sur les figures 3, 4 et 6 par exemple. De cette façon, chaque tête de préhension 5 s'adapte à la géométrie de la structure 2 à saisir par rotation permise par la rotule 12.

Par ailleurs, le dispositif de préhension 1 comporte encore un dispositif d'actionnement 10 de la préhension de la structure 2, configuré pour assurer l'aspiration par le biais du système d'aspiration 4, le soufflage par le biais desdits au moins trois systèmes de soufflage 9 et la rotation des têtes de préhension 5 de sorte à permettre la préhension de la structure 2.

Ce dispositif d'actionnement 10 est connecté à une source d'alimentation en gaz, par exemple un gaz comprimé, tel que de l'azote, ou de l'air.

Comme visible sur la figure 1, le dispositif d'actionnement 10 comporte un organe de préhension manuelle 15 pour un utilisateur afin de pouvoir manipuler la structure 2, celui-ci étant relié au corps principal 3 par le biais d'un bras d'actionnement 17. De plus, cet organe de préhension manuelle 15 comporte un bouton-poussoir 11 permettant le déclenchement de l'aspiration, du soufflage et de la rotation des têtes de préhension 5.

Plus précisément, la rotation des têtes de préhension 5 est assurée par le dispositif d'actionnement 10 au moyen de tiges d'actionnement reliées aux têtes de préhension 5 et au dispositif d'actionnement 10. Pour ce faire, le dispositif de préhension 1 comporte des tubes creux 16 comprenant les tiges d'actionnement, reliant les têtes de préhension 5 au dispositif d'actionnement 10, ces tiges étant actionnées par le bouton-poussoir 11.

Comme visible sur la figure 1, les tubes creux 16 sont disposés sur les bras de préhension 6, la face supérieure 3a du corps principal 3 et le bras d'actionnement 17. Ces tubes creux 16 convergent au sein d'un boîtier de regroupement 18, visible sur la figure 1, positionné sur la face supérieure 3a du corps principal 3, et qui est situé en superposition du système d'aspiration 4.

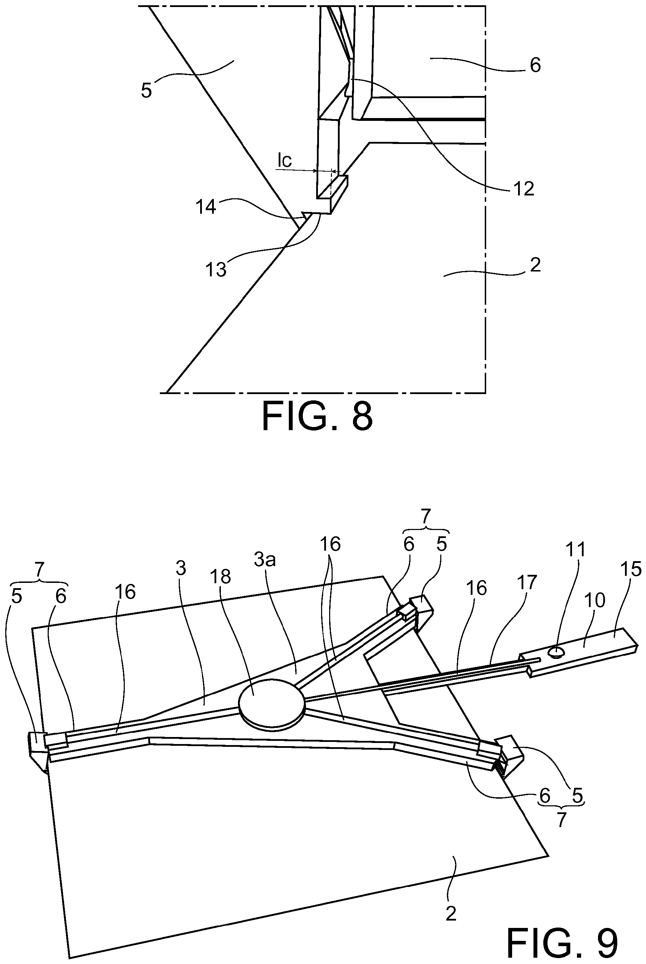

Par ailleurs, comme visible sur les figures 6 et 8, l'encoche de maintien en position 8 de chaque tête de préhension 6 est située à une extrémité de la tête de préhension 6. Elle comprend une paroi de contact sensiblement plane 13, destinée à venir au contact d'une surface supérieure de la structure 2, et qui coopère avec une paroi de contact sensiblement oblique 14, destinée à venir au contact d'une surface latérale de la structure 2, pour former l'encoche de maintien en position 8.

Ces parois de contact sensiblement plane 13 et oblique 14 définissent entre elles un angle d'encoche α strictement inférieur à 90°, et notamment supérieur ou égal à 45°. De plus, la largeur de contact lc de la paroi de contact sensiblement plane 13 avec la structure 2 est comprise entre 100 µm et 1 mm, étant par exemple comprise entre 100 µm et 500 µm. De la sorte, la détérioration de la structure 2 par le dispositif de préhension 1 est fortement minimisée.

Le fonctionnement du dispositif de préhension 1 est le suivant : l'opérateur saisit le dispositif 1 par le biais de l'organe de préhension 15 et le place au-dessus d'une structure 2 à manipuler. L'appui sur le bouton-poussoir 11 entraîne la rotation des têtes de préhension 5 (voir la figure 7) qui viennent alors agripper la structure 2 par le biais des encoches 8 pour la maintenir en position (voir la figure 8). Parallèlement, l'appui sur le bouton-poussoir 11 déclenche l'aspiration du système d'aspiration 4 qui permet de soulever la structure 2 et le soufflage des systèmes de soufflage 9 qui permettent de maintenir une distance de non contact entre le corps principal 3 et la structure 2.

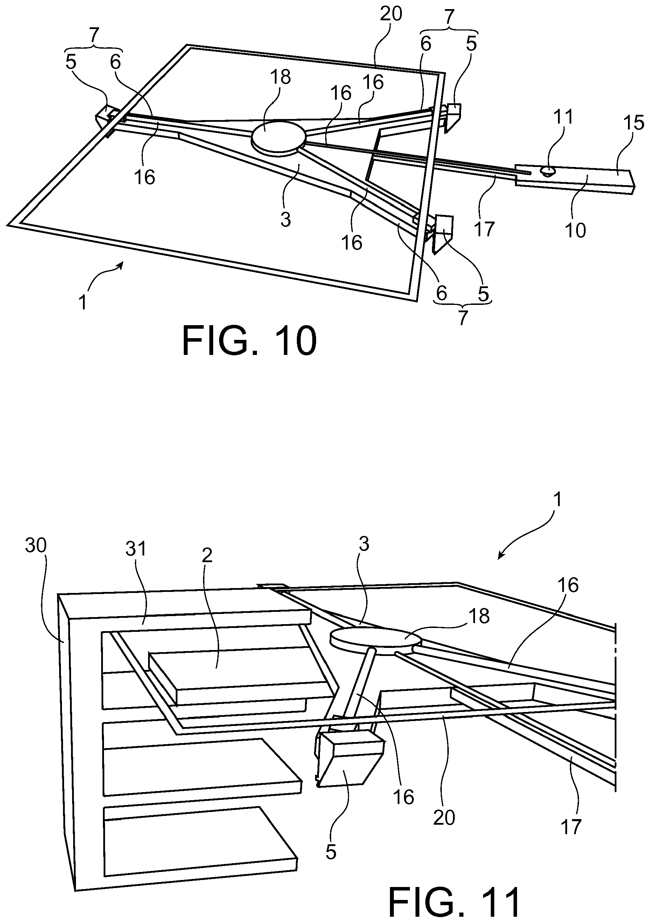

Les figures 10 et 11 permettent d'illustrer un deuxième exemple de réalisation d'un dispositif de préhension 1 conforme à l'invention, adapté à la prise d'une structure 2 dans un panier de stockage de structures 2.

En particulier, le dispositif de préhension 1 selon ce deuxième exemple est identique à celui décrit en référence aux figures 1 à 9 hormis le fait qu'il comporte un cadre 20 configuré pour permettre l'insertion du dispositif de préhension 1 dans un panier 30 de stockage de structures 2.

Ce panier 30 correspond notamment à un panier de stockage de wafers 2 pour lequel les dispositifs usuels de préhension de wafers ne sont pas adaptés.

L'ajout du cadre 20 facilite la prise du wafer 2 dans le panier 30. Plus précisément, comme visible sur la figure 11, l'appui du cadre 20 sur la partie inférieure de la dent 31 du panier 30 permet l'insertion du dispositif de préhension 1 plus facilement.

Bien entendu, l'invention n'est pas limitée aux exemples de réalisation qui viennent d'être décrits. L'invention est définie par les revendications.

## Revendications

1. Dispositif de préhension (1) d'une structure (2) monocouche ou multicouche, **caractérisé en ce qu'**il comporte :
- un corps principal (3) comprenant une face supérieure (3a) et une face inférieure (3b), opposée à la face supérieure (3a), le corps principal (3) comportant un système d'aspiration (4) de la structure (2) situé sur la face inférieure (3b) du corps principal (3) destinée à être en vis-à-vis de la structure (2),
- au moins trois systèmes de préhension (7) de la structure (2), reliés au corps principal (3), chaque système de préhension (7) comportant une tête de préhension (5), rotative selon les trois axes (X, Y, Z) d'un repère cartésien, pourvue d'une encoche de maintien en position (8) de la structure (2),
- au moins trois systèmes de soufflage (9) d'un gaz sur la structure (2), respectivement associés auxdits au moins trois systèmes de préhension (7), pour maintenir la structure (2) à distance du corps principal (3),
- un dispositif d'actionnement (10) de la préhension de la structure (2), configuré pour assurer l'aspiration par le biais du système d'aspiration (4), le soufflage par le biais desdits au moins trois systèmes de soufflage (9) et la rotation des têtes de préhension (5) de sorte à permettre la préhension de la structure (2).

2. Dispositif selon la revendication 1, **caractérisé en ce que** chaque système de préhension (7) comporte un bras de préhension (6), chaque bras de préhension (6) étant relié au corps principal (3) à l'une de ses extrémités et à une tête de préhension (5) à l'autre de ses extrémités.

3. Dispositif selon la revendication 2, **caractérisé en ce que** chaque système de soufflage (9) est situé à la jonction entre le corps principal (3) et un bras de préhension (6).

4. Dispositif selon la revendication 2 ou 3, **caractérisé en ce que** le corps principal (3) présente une forme sensiblement triangulaire, chaque bras de préhension (6) étant relié au corps principal (3) au niveau d'un sommet de la forme triangulaire.

5. Dispositif selon l'une des revendications 2 à 4, **caractérisé en ce que** chaque tête de préhension (5) est reliée au bras de préhension (6) correspondant par le biais d'une rotule (12).

6. Dispositif selon l'une quelconque des revendications précédentes, **caractérisé en ce que** l'encoche de maintien en position (8) de chaque tête de préhension (6) est situé à une extrémité de la tête de préhension (6) et comprend une paroi de contact sensiblement plane (13), destinée à venir au contact d'une surface inférieure ou supérieure de la structure (2), coopérant avec une paroi de contact sensiblement oblique (14), destinée à venir au contact d'une surface latérale de la structure (2), pour former l'encoche de maintien en position (8).

7. Dispositif selon la revendication 6, **caractérisé en ce que** les parois de contact sensiblement plane (13) et oblique (14) définissent entre elles un angle d'encoche (a) strictement inférieur à 90°, et notamment supérieur ou égal à 45°.

8. Dispositif selon la revendication 6 ou 7, **caractérisé en ce que** la largeur de contact (lc) de la paroi de contact sensiblement plane (13) avec la structure (2) est comprise entre 100 µm et 1 mm, notamment entre 100 µm et 500 µm.

9. Dispositif selon l'une quelconque des revendications précédentes, **caractérisé en ce que** le dispositif d'actionnement (10) comporte un organe de préhension manuelle (15) pour un utilisateur, notamment relié au corps principal (3) par le biais d'un bras d'actionnement (17).

10. Dispositif selon l'une quelconque des revendications précédentes, **caractérisé en ce que** le dispositif d'actionnement (10) comporte un bouton-poussoir (11) permettant le déclenchement de l'aspiration, du soufflage et de la rotation des têtes de préhension (5).

11. Dispositif selon l'une quelconque des revendications précédentes, **caractérisé en ce que** la rotation des têtes de préhension (5) est assurée par le dispositif d'actionnement (10) au moyen de tiges d'actionnement reliées aux têtes de préhension (5) et au dispositif d'actionnement (10).

12. Dispositif selon la revendication 11, **caractérisé en ce qu'**il comporte des tubes creux (16) comprenant les tiges d'actionnement, reliant les têtes de préhension (5) au dispositif d'actionnement (10).

13. Dispositif selon la revendication 12, **caractérisé en ce que** les tubes creux (16) sont disposés, au moins en partie, sur la face supérieure (3a) du corps principal (3).

14. Dispositif selon la revendication 13, **caractérisé en ce que** les tubes creux (16) convergent au sein d'un boîtier de regroupement (18) positionné sur la face supérieure (3a) du corps principal (3), notamment en superposition du système d'aspiration (4) situé sur la face inférieure (3b) du corps principal (3).

15. Dispositif selon l'une quelconque des revendications précédentes, **caractérisé en ce qu'**il comporte un cadre (20) configuré pour permettre l'insertion du dispositif de préhension (1) dans un panier (30) de stockage de structures (2).

## Patentansprüche

1. Vorrichtung (1) zum Ergreifen einer ein- oder mehrschichtigen Struktur (2), **dadurch gekennzeichnet, dass** sie enthält:
- einen Hauptkörper (3), der eine Oberseite (3a) und eine der Oberseite (3a) entgegengesetzte Unterseite (3b) aufweist, wobei der Hauptkörper (3) ein Ansaugsystem (4) für die Struktur (2) aufweist, das an der Unterseite (3b) des Hauptkörpers (3), die der Struktur (2) gegenüberliegen soll, angeordnet ist,
- zumindest drei Greifsysteme (7) zum Ergreifen der Struktur (2), die mit dem Hauptkörper (3) verbunden sind, wobei jedes Greifsystem (7) einen Greifkopf (5) enthält, der in den drei Achsen (X, Y, Z) eines kartesischen Koordinatensystems drehbar ist und mit einer Einkerbung (8) versehen ist, um die Struktur (2) in Stellung zu halten,
- zumindest drei Blassysteme (9) zum Blasen von Gas auf die Struktur (2), die den jeweiligen zumindest drei Greifsystemen (7) zugeordnet sind, um die Struktur (2) in Abstand von dem Hauptkörper (3) zu halten,
- eine Betätigungsvorrichtung (10) zum Ergreifen der Struktur (2), die dazu ausgelegt ist, das Ansaugen mit Hilfe des Ansaugsystems (4), das Blasen mit Hilfe der zumindest drei Blassysteme (9) und die Drehung der Greifköpfe (5) sicherzustellen, um das Ergreifen der Struktur (2) zu ermöglichen.

2. Vorrichtung nach Anspruch 1, **dadurch gekennzeichnet, dass** jedes Greifsystem (7) einen Greifarm (6) enthält, wobei jeder Greifarm (6) an dem einen Ende mit dem Hauptkörper (3) und an dem anderen Ende mit einem Greifkopf (5) verbunden ist.

3. Vorrichtung nach Anspruch 2, **dadurch gekennzeichnet, dass** jedes Blassystem (9) an der Verbindungsstelle zwischen dem Hauptkörper (3) und einem Greifarm (6) angeordnet ist.

4. Vorrichtung nach Anspruch 2 oder 3, **dadurch gekennzeichnet, dass** der Hauptkörper (3) eine im Wesentlichen dreieckige Form aufweist, wobei jeder Greifarm (6) mit dem Hauptkörper (3) an einem Scheitelpunkt der Dreiecksform verbunden ist.

5. Vorrichtung nach einem der Ansprüche 2 bis 4, **dadurch gekennzeichnet, dass** jeder Greifkopf (5) über ein Kugelgelenk (12) mit dem entsprechenden Greifarm (6) verbunden ist.

6. Vorrichtung nach einem der vorstehenden Ansprüche, **dadurch gekennzeichnet, dass** die Einkerbung (8) zum Halten jedes Greifkopfes (6) in Stellung an einem Ende des Greifkopfes (6) angeordnet ist und eine im Wesentlichen ebene Kontaktwand (13) aufweist, die dazu bestimmt ist, mit einer unteren oder oberen Fläche der Struktur (2) in Kontakt zu kommen, und die mit einer im Wesentlichen schrägen Kontaktwand (14) zusammenwirkt, die dazu bestimmt ist, mit einer Seitenfläche der Struktur (2) in Kontakt zu gelangen, um die Einkerbung (8) zum Stellungshalten zu bilden.

7. Vorrichtung nach Anspruch 6, **dadurch gekennzeichnet, dass** die im Wesentlichen ebene (13) und die schräge (14) Kontaktwand zwischen sich einen Kerbwinkel (α) definieren, der strikt kleiner als 90° und insbesondere größer oder gleich 45° ist.

8. Vorrichtung nach Anspruch 6 oder 7, **dadurch gekennzeichnet, dass** die Kontaktbreite (lc) der im Wesentlichen ebenen Kontaktwand (13) mit der Struktur (2) zwischen 100 µm und 1 mm, insbesondere zwischen 100 µm und 500 µm, liegt.

9. Vorrichtung nach einem der vorstehenden Ansprüche, **dadurch gekennzeichnet, dass** die Betätigungsvorrichtung (10) ein manuelles Greifelement (15) für einen Benutzer enthält, das insbesondere mit dem Hauptkörper (3) mittels eines Betätigungsarms (17) verbunden ist.

10. Vorrichtung nach einem der vorstehenden Ansprüche, **dadurch gekennzeichnet, dass** die Betätigungsvorrichtung (10) einen Druckknopf (11) enthält, mit dem das Ansaugen, das Blasen und das Drehen der Greifköpfe (5) ausgelöst werden kann.

11. Vorrichtung nach einem der vorstehenden Ansprüche, **dadurch gekennzeichnet, dass** das Drehen der Greifköpfe (5) über die Betätigungsvorrichtung (10) mittels Betätigungsstangen sichergestellt wird, die mit den Greifköpfen (5) und mit der Betätigungsvorrichtung (10) verbunden sind.

12. Vorrichtung nach Anspruch 11, **dadurch gekennzeichnet, dass** sie hohl ausgeführte Röhren (16) enthält, die die Betätigungsstangen enthalten und die Greifköpfe (5) mit der Betätigungsvorrichtung (10) verbinden.

13. Vorrichtung nach Anspruch 12, **dadurch gekennzeichnet, dass** die hohl ausgeführten Röhren (16) zumindest teilweise an der Oberseite (3a) des Hauptkörpers (3) angeordnet sind.

14. Vorrichtung nach Anspruch 13, **dadurch gekennzeichnet, dass** die hohl ausgeführten Röhren (16) innerhalb eines Montagegehäuses (18) zusammenlaufen, das an der Oberseite (3a) des Hauptkörpers (3) angeordnet ist, insbesondere in Überlagerung mit dem Ansaugsystem (4), das an der Unterseite (3b) des Hauptkörpers (3) angeordnet ist.

15. Vorrichtung nach einem der vorstehenden Ansprüche, **dadurch gekennzeichnet, dass** sie einen Rahmen (20) aufweist, der dazu ausgelegt ist, das Einführen der Greifvorrichtung (1) in einen Korb (30) zur Lagerung von Strukturen (2) zu ermöglichen.

## Claims

1. Gripping device (1) for gripping a single-layer or multi-layer structure (2), **characterised in that** it includes:
- a main body (3) comprising a top face (3a) and a bottom face (3b), opposite the top face (3a), the main body (3) including a system (4) for applying suction to the structure (2) located on the bottom face (3b) of the main body (3) intended to be facing the structure (2),
- at least three systems (7) for gripping the structure (2), which are connected to the main body (3), each gripping system (7) including a gripping head (5), capable of rotating about the three axes (X, Y, Z) of a Cartesian coordinate system, provided with a notch (8) for holding the structure (2) in position,
- at least three systems (9) for blowing a gas onto the structure (2), which are respectively associated with said at least three gripping systems (7), to hold the structure (2) at a distance from the main body (3),
- a device (10) for actuating the gripping of the structure (2), which is configured to ensure suction via the suction system (4), blowing via said at least three blowing systems (9) and rotation of the gripping heads (5) to allow the structure (2) to be gripped.

2. Device according to claim 1, **characterised in that** each gripping system (7) includes a gripping arm (6), each gripping arm (6) being connected to the main body (3) at one of the ends thereof and to a gripping head (5) at the other end thereof.

3. Device according to claim 2, **characterised in that** each blowing system (9) is located at the junction between the main body (3) and a gripping arm (6).

4. Device according to claim 2 or 3, **characterised in that** the main body (3) has a substantially triangular shape, each gripping arm (6) being connected to the main body (3) at an apex of the triangular shape.

5. Device according to one of claims 2 to 4, **characterised in that** each gripping head (5) is connected to the corresponding gripping arm (6) via a ball joint (12).

6. Device according to any of the preceding claims, **characterised in that** the position-holding notch (8) of each gripping head (6) is located at one end of the gripping head (6) and comprises a substantially planar contact wall (13), intended to come into contact with a bottom or top surface of the structure (2), cooperating with a substantially oblique contact wall (14), intended to come into contact with a side surface of the structure (2), to form the position-holding notch (8).

7. Device according to claim 6, **characterised in that** the substantially planar contact wall (13) and the substantially oblique contact wall (14) define therebetween a notch angle (α) of strictly less than 90°, and in particular greater than or equal to 45°.

8. Device according to claim 6 or 7, **characterised in that** the width of contact (Ic) between the substantially planar contact wall (13) and the structure (2) lies in the range 100 µm to 1 mm, in particular in the range 100 µm to 500 µm.

9. Device according to any of the preceding claims, **characterised in that** the actuating device (10) includes a manual gripping member (15) for a user, that is in particular connected to the main body (3) via an actuating arm (17).

10. Device according to any of the preceding claims, **characterised in that** the actuating device (10) includes a push button (11) allowing the suction, blowing and rotation of the gripping heads (5) to be initiated.

11. Device according to any of the preceding claims, **characterised in that** the rotation of the gripping heads (5) is carried out by the actuating device (10) by means of actuating rods connected to the gripping heads (5) and to the actuating device (10).

12. Device according to claim 11, **characterised in that** it includes hollow tubes (16) comprising the actuating rods, connecting the gripping heads (5) to the actuating device (10).

13. Device according to claim 12, **characterised in that** the hollow tubes (16) are disposed, at least in part, on the top face (3a) of the main body (3).

14. Device according to claim 13, **characterised in that** the hollow tubes (16) converge inside a unification box (18) positioned on the top face (3a) of the main body (3), in particular superimposed over the suction system (4) situated on the bottom face (3b) of the main body (3).

15. Device according to any of the preceding claims, **characterised in that** it includes a frame (20) configured to allow the gripping device (1) to be inserted into a box (30) for storing structures (2).
